# FASCICULE DE BREVET EUROPEEN

(11) **EP 0 414 618 B1**
(45) Date de publication et mention de la délivrance du brevet: **15.03.1995**
(21) Numéro de dépôt: 90420286.8
(22) Date de dépôt: 18.06.1990
(51) Int. Cl.: H01L 29/786, H01L 29/84, H01L 27/088

(54) **Transistor MOS en couche mince avec la zone de canal reliée à la source et son procédé de fabrication**
Dünnfilm-MOS-Transistor, bei dem die Kanalzone mit der Source verbunden ist, und Verfahren zur Herstellung
Thin film MOS transistor with the channel region connected to the source and method of fabrication

(30) Priorité: 19.06.1989 FR 8908428
(43) Date de publication de la demande: 27.02.1991
(73) Titulaire: FRANCE TELECOM, 75015 Paris (FR)
(72) Inventeur: Haond, Michel, F-38240 Meylan (FR)
(74) Mandataire: de Beaumont, Michel

(56) Documents cités:
- EP-A- 0 225 821
- EP-A- 0 304 811
- EP-A- 0 315 424
- FR-A- 2 520 556
- PATENT ABSTRACTS OF JAPAN, vol. 10, no. 129 (E-403)[2186], 14 mai 1986;& JP-A-60 258 957

## Description

La présente invention concerne le domaine des transistors MOS fabriqués dans une couche mince de silicium formée sur un substrat isolant.

Dans les technologies de silicium sur isolant, les transistors élémentaires sont formés dans des portions d'une couche monocristalline de silicium sur isolant. On distingue deux types principaux de technologies selon la façon dont les transistors individuels sont isolés les uns des autres.

Selon une première technologie, chacun des transistors MOS est formé dans un plateau, un mésa, de la couche mince de silicium monocristallin, chacun des plateaux étant séparé des autres par une élimination de la couche mince de silicium.

Selon une deuxième technologie, les portions dans lesquelles sont formées chacun des transistors sont séparées les unes des autres par un isolement diélectrique, généralement par oxydation des régions de la couche mince autres que celles dans lesquelles ont veut former les transistors.

On décrira d'abord l'état de la technique et la présente invention dans le cadre d'une technologie de type mésa, et on décrira ensuite une variante de la présente invention dans le cadre d'une technologie de type à isolement diélectrique.

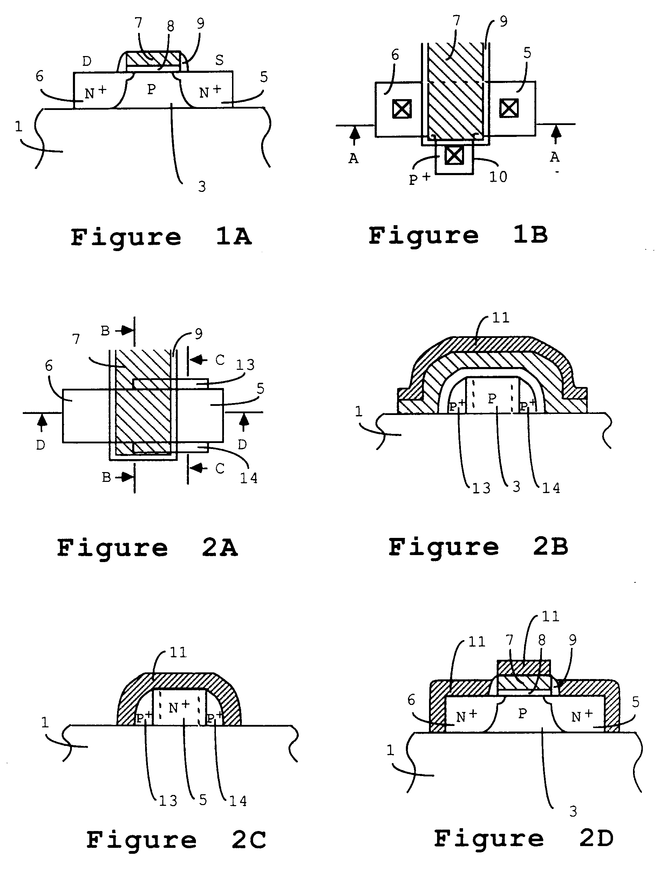

Les figures 1A et 1B représentent une vue en coupe et une vue de dessus d'un transistor MOS classique formé sur silicium sur isolant (la figure 1A étant une vue en coupe selon la ligne A-A de la figure 1B).

Comme le représentent ces figures, une telle structure est formée à partir d'une couche mince de silicium monocristallin sur un substrat 1. Cette couche mince de silicium est gravée pour qu'il reste en place seulement un pavé dont la partie centrale correspondra à un caisson 3 faiblement dopé d'un premier type de conductivité, ici de type P, faiblement dopé dans la partie supérieure duquel se formera un canal sous l'effet d'une grille, et dont les régions extrêmes correspondront à une source 5 et à un drain 6 fortement dopés du type opposé à celui du caisson, ici N⁺. Une grille conductrice 7 est formée au-dessus de la région de canal du caisson avec interposition d'une couche isolante 8. Couramment, la grille 7 est en silicium polycristallin et la couche d'isolement de grille 8 en oxyde de silicium. En outre, de façon classique, des espaceurs isolants 9, couramment en oxyde de silicium ou en nitrure de silicium, sont formés de part et d'autre de la grille et ont pour but d'une part de permettre la formation d'implantations de drain et de source ayant l'allure représentée, c'est-à-dire pénétrant plus profondément sous la grille dans leur partie supérieure, et d'autre part d'assurer un isolement entre le contact le grille et les contacts de drain et de source.

Dans la vue de dessus de la figure 1B, on retrouve les éléments décrits dans la vue de la figure 1A avec les mêmes références. On a représenté par des croix dans des carrés les contacts de drain et de source.

En outre, il est connu dans le domaine de l'utilisation des transistors MOS qu'il est souhaitable de prévoir un contact entre la région de caisson 3 et la région de source 5 pour éviter divers effets parasites à savoir :
1) l'effet "kink" lié à l'existence d'un caisson flottant lorsque la couche de silicium sur isolant est trop épaisse et/ou trop dopée (cet effet se manifeste sous la forme d'une bosse sur la caractéristique courant de drain/tension de drain) ;
2) l'effet d'apparition d'un transistor bipolaire parasite qui introduit une hystérésis dans les caractéristiques courant-tension du transistor ;
3) l'effet d'apparition d'un transistor parasite de bord lié à l'isolement latéral.

Pour réaliser un tel contact entre le caisson et la source, la solution classique telle qu'illustrée en figure 1B consiste à prévoir un prolongement de la portion de silicium monocristallin correspondant au caisson, ce prolongement étant désigné par la référence 10 en figure 1B et à prévoir un contact sur ce prolongement, ce contact étant ensuite relié par une métallisation au contact de la source 5. Le prolongement 10 doit être dopé du même type que le substrat mais à plus fort niveau de dopage (P⁺ dans l'exemple illustré). Cette structure classique présente l'inconvénient évident d'augmenter la surface de chaque transistor élémentaire. En effet, la surface nécessaire pour un contact est pratiquement du même ordre de grandeur, dans le cadre des technologies actuelles, que les dimensions de source de drain ou de canal d'un transistor. A titre d'exemple, dans une réalisation actuelle, l'épaisseur de la couche de silicium monocristallin sera de l'ordre de 200 nm et chaque pavé de transistor aura des dimensions de l'ordre de 2000 x 5000 nm alors que la région 10 qui a pour seul rôle de permettre l'établissement d'un contact devra avoir des dimensions de l'ordre de 2000 x 2000 nm. De plus, la résistance d'accès entre ce contact et le caisson lui-même devient prohibitive quand les dimensions des transistors diminuent.

Un tel contact caisson-source est également prévu dans les documents EP-A-0 315 424, FR-A-2 520 556 et EP-A-0 304 811 mais tous ces documents prévoient des contacts ayant l'un et/ou l'autre des trois inconvénients suivants : mauvaise résistance d'accès, structure complexe, augmentation de surface.

Un objet de la présente invention est de prévoir une nouvelle structure de transistor MOS formé dans une couche de silicium sur isolant dans laquelle il est prévu un contact entre caisson et source, ce contact n'augmentant pratiquement pas la surface du transistor.

Un autre objet de la présente invention est de prévoir un procédé particulier de fabrication d'une telle structure dans le cadre de transistors MOS de type mésa à silicium sur isolant.

Un autre objet de la présente invention est de prévoir un procédé particulier de fabrication d'une telle structure dans le cadre de transistors MOS du type à isolement diélectrique.

Pour atteindre ces objets ainsi que d'autres, la présente invention prévoit un transistor MOS du type connu de EP-A-0 315 424 comprenant au moins une bande latérale fortement dopée du type de conductivité du caisson dans lequel se forme la région de canal, cette bande s'étendant le long du bord du caisson.

Un procédé de fabrication d'un transistor MOS selon un premier mode de réalisation de la présente invention comprend, après la gravure des zones mésas, et tandis que le masque (oxyde-nitrure) ayant servi à délimiter les mésas est encore en place, les étapes suivantes :
former une couche de silicium polycristallin recouvrant l'ensemble de la structure ;
graver cette couche de silicium polycristallin par attaque anisotrope de façon à laisser en place seulement un espaceur entourant chacun des mésas ;
graver l'espaceur pour laisser en place seulement les bandes latérales désirées s'étendant de long d'une partie de la région de caisson et le long de la région de source adjacente ;
continuer selon le processus classique de fabrication d'un transistor MOS sur isolant de type mésa.

Un procédé de fabrication d'un transistor MOS selon un deuxième mode de réalisation de la présente invention comprend, après l'étape de gravure d'un premier masque servant à délimiter des régions d'oxydation séparant chacun des transistors individuels, tandis que ce masque (oxyde-nitrure) est encore en place, et avant l'étape d'oxydation, les étapes suivantes :
former un deuxième masque comprenant une ouverture au moins le long d'une bande latérale débordant par rapport à la région de source et à la région de caisson ;
procéder à une implantation du type de conductivité du caisson à fort niveau de dopage ;
procéder à un recuit ;
éliminer le deuxième masque ;
procéder à une étape d'oxydation pour isoler les portions dans lesquelles sont formés les transistors MOS ; et
continuer selon le processus classique de fabrication d'un transistor MOS sur isolant à isolement diélectrique.

Ces objets, caractéristiques et avantages ainsi que d'autres de la présente invention seront exposés plus en détail dans la description suivante de modes de réalisation particuliers faite en relation avec les figures jointes parmi lesquelles :
les figures 1A et 1B représentent respectivement une vue en coupe et une vue de dessus d'un transistor MOS du type silicium sur isolant selon l'art antérieur ;
les figures 2A, 2B, 2C et 2D représentent respectivement une vue de dessus et diverses vues en coupe d'un transistor selon la présente invention de type mésa ;
les figures 3A à 8A représentent de façon schématique, selon des vues en coupe, des étapes successives de fabrication d'un transistor MOS selon la présente invention de type mésa, et les figures 3B à 8B représentent des vues de dessus correspondantes ; et
les figures 9A à 11A représentent des vues en coupe successives illustrant un procédé de fabrication d'un transistor selon la présente invention du type à isolement diélectrique, et les figures 9B à 11B sont des vues de dessus correspondantes.

Dans les diverses figures, de mêmes références désignent de mêmes éléments ou couches. D'autre part, on notera que, conformément à l'usage dans le domaine de la représentation des circuits intégrés, les diverses régions, zones et couches ne sont pas tracées à l'échelle ni d'une figure à l'autre ni à l'intérieur d'une même figure dans le but d'améliorer l'intelligibilité des figures. L'homme de l'art pourra se référer aux valeurs classiquement connues ou à celles spécifiquement indiquées dans la présente description.

Les figures 2A à 2D illustrent un transistor selon la présente invention, de type mésa. Les figures 2B, 2C et 2D sont des vues en coupe selon les plans BB, CC, et DD indiqués dans la vue de dessus de la figure 2A. On retrouve dans ces figures le substrat 1 et le pavé de silicium monocristallin comprenant les régions de caisson 3, de source 5 et de drain 6, ainsi que la grille 7 et l'espaceur latéral de grille 9. On a en outre représenté en figures 2B, 2C et 2D, mais pas en figure 2A, une couche supérieure de siliciure 11 qui se localise automatiquement sur les régions apparentes de silicium mono ou polycristallin.

Selon l'invention, on ajoute à une structure classique de transistor au moins une bande latérale de silicium polycristallin conducteur du même type de conductivité que le caisson. De telles bandes 13 et 14 apparaissent dans les figures 2A, 2B et 2C. Ces bandes s'étendent de part et d'autre de la longueur d'un pavé de transistor de façon à être en contact latéralement avec une partie de la région de caisson et une partie au moins de la région de source. Comme elles sont du même type de conductivité que le caisson, ces bandes sont en contact électrique avec lui et la région de siliciure de source 11 établit un contact entre ces bandes 13 et 14 et la source 5. On notera en outre que, par suite des diverses opérations de recuit réalisées après les implantations, le dopant des régions 13 et 14 diffuse partiellement dans les parties latérales des régions de caisson et de source, comme cela est indiqué par des pointillés en figures 2B et 2C.

Avec une telle structure, on obtient un contact caisson/source sans augmenter sensiblement la dimension d'un pavé de transistor MOS du type silicium sur isolant. On va montrer ci-après qu'une telle structure est facilement réalisable aussi bien dans le cadre d'une réalisation de type mésa que d'une réalisation du type à isolement diélectrique.

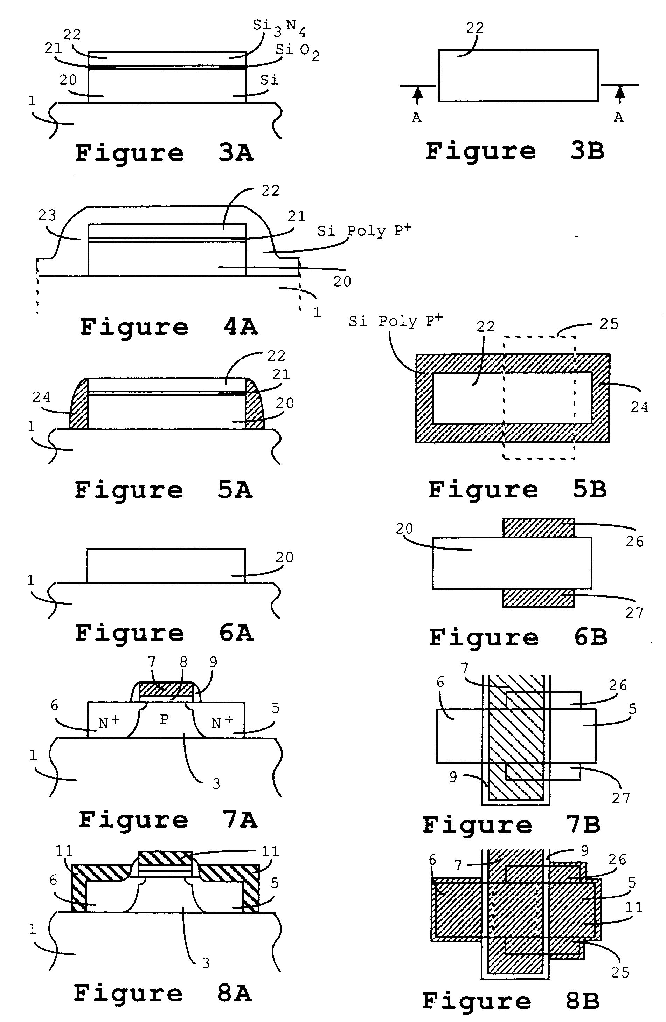

Les figures 3A à 8A sont des vues en coupe et les figures 3B à 8B des vues de dessus correspondantes d'étapes successives de fabrication d'un transistor MOS de type mésa à court-circuit caisson-source selon la présente invention.

La figure 3A représente une étape préliminaire classique de fabrication dans laquelle, étant donnée une couche mince de silicium monocristallin formée sur un substrat 1, on délimite un pavé 20 de silicium en prévoyant un revêtement par une couche de masquage, par exemple un sandwich d'oxyde de silicium (SiO₂) 21 et de nitrure de silicium 22, l'ensemble ayant par exemple une épaisseur de l'ordre de 80 nm.

A l'étape suivante, illustrée à la figure 4A, l'ensemble de la tranche est revêtu d'une couche de silicium polycristallin 23. Dans un mode de réalisation, ce silicium polycrystallin peut être initialement fortement dopé de type P⁺. On procède ensuite à une gravure anisotrope sélective, par exemple sous plasma, de la couche de silicium polycristallin 23 pour obtenir un pavé (20, 21, 22) entouré d'un espaceur de silicium polycristallin de type P⁺ 24 et, comme le représente la figure 5B, ce pavé est partiellement revêtu d'un masque qui recouvre au moins une partie de la région où doit être formé le caisson central et de la région où doit être formée la source. On procède alors à une attaque sélective du silicium polycristallin qui se produit aux emplacements autres que celui du masque 25 et, après élimination des couches de nitrure de silicium 22 et d'oxyde de silicium 21, on obtient un pavé de silicium monocristallin 20 muni d'espaceurs localisés 26, 27 s'étendant longitudinalement sur les bords du pavé le long de la région de caisson et de la région de source.

On procède ensuite aux étapes normales de fabrication d'un transistor MOS pour former une grille de silicium polycristallin 7 au-dessus d'un oxyde de grille 8. Après quoi on procède à une première implantation de source et de drain puis on forme les espaceurs isolants de grille 9 et l'on procède à une deuxième implantation de source et de drain pour obtenir la région de caisson 3 et les régions de source et de drain 5 et 6.

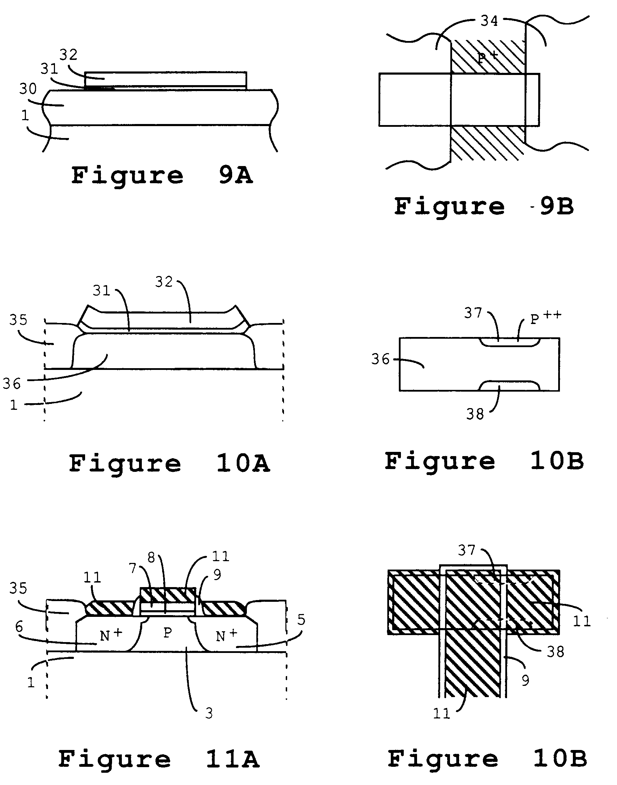

Enfin comme l'illustrent les figures 8A et 8B on peut former une couche d'un siliciure métallique qui s'aligne automatiquement sur toutes les régions apparentes de silicium et de silicium polycristallin. Ce siliciure est désigné par le référence 11 comme en figure 2D. On notera, comme le montre bien la figure 8B, que la couche de siliciure 11 formée au-dessus de la région de source se forme également au-dessus des régions de silicium polycristallin 26 et 27 et assure le court-circuit source/caisson recherché. En outre, bien que cela ne soit pas représenté dans les figures, on notera qu'à la suite des étapes successives d'implantation et de recuit, la région de silicium polycristallin fortement dopée correspondant aux espaceurs 26 et 27 entraînera la diffusion de dopants de type P⁺ dans les régions adjacentes de source et de caisson.

D'autre part, l'homme de l'art aura noté que la concentration en dopant de type P⁺ dans les régions 26 et 27 doit être supérieure à la concentration de dopant de type N⁺ dans les régions de drain et de source pour que l'implantation de source ne vienne pas neutraliser le dopage des zones latérales. Par exemple, si les implantations de source sont de l'ordre de 2 à 4 10¹⁵ atomes de phosphore ou d'arsenic par cm², l'implantation des bandes latérales sera de l'ordre de 4 à 6 10¹⁵ atomes de bore de cm². Enfin, on pourra aussi noter que, si l'on considère la figure 5A, il restera en place, après élimination des couches 21 et 22 (qui n'ont qu'une épaisseur de l'ordre de 80 nm), des reliefs de silicium polycrystallin. En fait, ces reliefs disparaîtront ou seront à tout le moins fortement atténués par suite des étapes successives d'oxydation et d'élimination de l'oxyde prévues ultérieurement puisque, quand on réalise une oxydation, le silicium polycristallin s'oxyde nettement plus vite que le silicium monocristallin.

Le cas de la réalisation d'une structure de la présente invention dans le cadre d'un procédé de fabrication de transistor sur couche mince de silicium à isolement diélectrique va être décrit en relation avec les vues en coupe des figures 9A à 11A et des vues de dessus des figures 9B à 11B.

La figure 9A représente une couche mince de silicium monocristallin 30 formée sur un substrat isolant 1, les régions où l'on veut former des transistors étant revêtues d'une couche de protection à l'encontre d'une oxydation, constituée par exemple d'un sandwich d'oxyde de silicium 31 et de nitrure de silicium 32. Ensuite, comme le représente la figure 9B, on forme un masque 34 comprenant une ouverture chevauchant les régions de caisson et de source du transistor que l'on veut former et l'on procède à une implantation d'un dopant de type P⁺ (même type que celui du caisson), cette implantation étant masquée d'une part par le masque 34, d'autre part par la couche de nitrure de silicium 32.

Après cela, comme l'illustrent les figures 10A et 10B, on procède à la croissance de l'oxyde d'isolement épais 35 séparant des portions de silicium monocristallin 36. Pendant cette étape d'oxydation, le dopant de type P⁺ implanté à l'étape illustrée en figure 9B diffuse latéralement dans la portion de silicium monocristallin 36 pour former des bandes P⁺ 37 et 38 telles qu'illustrées en figure 10B.

On procède ensuite à la succession d'étapes classiques pour fabriquer un transistor MOS et la couche finale de siliciure 11 ou autre couche de métallisation formée sur la région de source court-circuite les régions superficielles 37 et 38 (ainsi que les régions latérales) avec la région de source. On a reporté en figure 11A les mêmes références qu'en figures 8A et 2D.

Ainsi, la présente invention permet de fabriquer selon l'une ou l'autre des technologies de type mésa ou de type à isolement diélectrique des pavés de transistors MOS à court-circuit caisson-source de façon simple. En effet il n'y a aucune exigence d'alignement précis entre le masque destiné à la délimitation des bandes latérales et les autres masques utilisés dans le processus de fabrication des transistors MOS.

Par ailleurs, l'homme de l'art notera que les différentes variantes de fabrication des transistors MOS sont compatibles avec la présente invention, en particulier en ce qui concerne les types de dopage et la prévision d'étapes supplémentaires telles que des implantations de canal. De même les contacts n'impliquent pas nécessairement l'utilisation de siliciures métalliques.

## Revendications

1. Transistor MOS formé dans une portion isolée d'une couche mince de silicium monocristallin sur isolant, comprenant une région de source (5), une région de drain (6) et un caisson (3) dans lequel est disposée la région de canal, la région de source (5) comprenant une couche conductrice de source (11) et comprenant en plus au moins une bande latérale (13,14 ; 26,27 ; 37,38) fortement dopée du type de conductivité du caisson (3), cette bande s'étendant le long du bord de la région de source (5), et étant mise en court-circuit avec la région de source par la couche conductrice de source (11) caractérisé en ce que cette bande s'étend également le long du bord du caisson, sous la couche d'isolement de grille et la couche de grille.

2. Transistor selon la revendication 1, caractérisé en ce que la couche conductrice de source (11) est une couche de siliciure métallique.

3. Transistor MOS selon l'une des revendications 1 ou 2, dans lequel ladite portion isolée est de type mésa, c'est-à-dire qu'elle est séparée des autres portions isolées par une absence de couche mince de silicium monocristallin, caractérisé en ce que ladite bande latérale comprend au moins en partie un espaceur de silicium fortement dopé.

4. Transistor selon la revendication 3, caractérisé en ce que ledit espaceur de silicium fortement dopé est en silicium polycristallin.

5. Transistor MOS selon l'une des revendications 1 ou 2, caractérisé en ce que ladite bande latérale est une région surdopée directement formée dans une partie latérale des régions correspondant normalement au caisson et à la source.

6. Transistor MOS selon la revendication 5, dans lequel ladite portion isolée est du type à isolement diélectrique.

7. Procédé de fabrication d'un transistor MOS selon la revendication 4, caractérisé en ce que, après la gravure des zones mésas, et tandis que le masque ayant servi à délimiter les mésas est encore en place, il comprend les étapes suivantes :
former une couche de silicium polycristallin recouvrant l'ensemble de la structure ;
graver cette couche de silicium polycristallin par attaque anisotrope de façon à laisser en place seulement un espaceur entourant chacun des mésas, le silicium polycristallin étant fortement dopé selon le même type de conductivité que le caisson pendant son dépôt ;
graver l'espaceur de façon à laisser en place seulement les bandes latérales désirées s'étendant le long d'une partie de la région de caisson et le long de la région de source adjacente.

8. Procédé de fabrication d'un transistor MOS selon la revendication 6, caractérisé en ce que, après l'étape de gravure d'un premier masque servant à délimiter des régions d'oxydation séparant chacun des transistors individuels, tandis que ce masque est encore en place, et avant l'étape d'oxydation, il comprend les étapes suivantes :
former un deuxième masque comprenant une ouvertre au moins le long d'une bande latérale débordant par rapport à la région de source et à la région de caisson ;
procéder à une implantation du type de conductivité du caisson à fort niveau de dopage ;
procéder à un recuit;
éliminer le deuxième masque ;
procéder à une étape d'oxydation pour isoler les portions dans lesquelles sont formée les transistors MOS.

## Patentansprüche

1. MOS-Transistor, der in einem isolierten Bereich einer dünnen Schicht monokristallinen Siliziums auf einer Isolierung ausgebildet ist, mit einem Source-Bereich (5), einem Drain-Bereich (6) und einem Graben (3), in dem der Kanalbereich angeordnet ist, wobei der Source-Bereich (5) eine leitende Source-Schicht (11) und darüberhinaus einen stark dotierten seitlichen Streifen (13, 14; 26, 27; 37, 38) vom Leitungstyp des Grabens (3) aufweist, wobei dieser Streifen sich entlang des Randes des Source-Bereiches (5) erstreckt und mit dem Source-Bereich durch die leitende Source-Schicht (11) kurzgeschlossen ist, dadurch gekennzeichnet, daß dieser Streifen sich ebenfalls entlang des Randes des Grabens unterhalb der Isolationsschicht des Gates und der Gate-Schicht erstreckt.

2. Transistor nach Anspruch 1, dadurch gekennzeichnet, daß die leitende Source-Schicht (11) eine Schicht metallischen Silizids ist.

3. MOS-Transistor nach einem der Ansprüche 1 oder 2, bei dem der isolierte Bereich vom Mesa-Typ ist, d.h. daß er von den anderen isolierten Bereichen durch Fortlassen der dünnen Schicht monokristallinen Siliziums getrennt ist, dadurch gekennzeichnet, daß der besagte seitliche Streifen mindestens teilweise einen Trennbereich aus hochdotiertem Silizium aufweist.

4. Transistor nach Anspruch 3, dadurch gekennzeichnet, daß der Trennbereich aus hochdotiertem Silizium aus polykristallinem Silizium ist.

5. MOS-Transistor nach einem der Ansprüche 1 oder 2, dadurch gekennzeichnet, daß der seitliche Streifen ein überdotierter Bereich ist, der direkt in einer seitlichen Partie der Bereiche ausgebildet ist, die üblicherweise dem Graben und der Source entsprechen.

6. MOS-Transistor nach Anspruch 5, bei dem der isolierte Bereich vom Typ her ein Bereich mit dielektrischer Isolation ist.

7. Verfahren zur Herstellung eines MOS-Transistors nach Anspruch 4, dadurch gekennzeichnet, daß nach dem Ätzen der Mesa-Zonen und solange die Maske zum Begrenzen der MesaBereiche noch vorhanden ist, das Verfahren die folgenden Schritte aufweist:
Ausbilden einer Schicht polykristallinen Siliziums, die die gesamte Struktur überdeckt;
anisotropes Ätzen dieser Schicht aus polykristallinem Silizium derart, daß lediglich ein Trennbereich um jeden der Mesa-Bereiche belassen wird, wobei das polykristalline Silizium nach dem gleichen Leitfähigkeitstyp wie der Graben während seiner Ablagerung hochdotiert wird;
Ätzen der Trennbereiche derart, daß lediglich die gewünschten seitlichen Streifen belassen werden, die sich längs eines Teiles des Grabenbereiches und längs des benachbarten Source-Bereiches erstrecken.

8. Verfahren zur Herstellung eines MOS-Transistors nach Anspruch 6, dadurch gekennzeichnet, daß nach dem Ätzschritt einer ersten Maske, die zum Begrenzen der Oxidationsbereiche dient, welche die einzelnen Transistoren voneinander trennen, und solange diese Maske noch vorhanden ist, und vor dem Oxidationsschritt das Verfahren die folgenden Schritte aufweist:
Bilden einer zweiten Maske mit einer Öffnung zumindest entlang eines seitlichen Streifens, der den Source-Bereich und den Caisson-Bereich am Rand überdeckt;
Ausführen einer Implantation mit einem Leitfähigkeitstyp des Grabens mit hoher Dotierung;
Ausführen eines Sinterschrittes;
Entfernen der zweiten Maske;
Ausführen eines Oxidationsschrittes, um die Bereiche, in denen die MOS-Transistoren gebildet werden, zu isolieren.

## Claims

1. A MOS transistor formed in an insulated portion of a thin monocrystalline silicon layer on an insulator, comprising a source region (5), a drain region (6), and a substrate (3) in which a channel region is disposed, the source region (5) comprising a conductive source layer (11), and further comprising at least one highly doped lateral stripe (13,14; 26,27; 37,38) of the same conductivity type as the substrate (3), said stripe extending along the edge of the source region (5) and being shorted with the source region through the conductive source layer (11), characterized in that said stripe also extends along the edge of the well, under the gate insulation layer and the gate layer.

2. A MOS transistor according to claim 1, characterized in that the conductive source layer (11) is a metal silicide layer.

3. A MOS transistor according to claim 1 or 2, wherein said insulated portion is of the mesa-type, that is, is separated from the other insulated portions by a gap in said monocrystalline silicon layer, characterized in that said lateral stripe comprises, at least partially, a highly doped silicon spacer.

4. A MOS transistor according to claim 3, characterized in that said highly doped silicon spacer is made of polycrystalline silicon.

5. A MOS transistor according to claim 1 or 2, characterized in that said lateral stripe is an overdoped region directly formed in a lateral portion of the regions normally corresponding to the substrate and the source.

6. A MOS transistor according to claim 5, characterized in that said insulated portion is dielectrically insulated.

7. A method for manufacturing a MOS transistor according to claim 5, characterized in that, after etching the mesa through a mask, and while said is still in place, it comprises the following steps:
coating the whole structure with a polycrystalline silicon layer;
anisotropically etching said polycrystalline silicon layer so as to leave in place only a spacer surrounding each mesa, said polycrystalline silicon layer being highly doped according to the same conductivity type as the substrate, during its deposition;
etching the spacer for leaving in place only the desired lateral stripes extending along a portion of the substrate region and along the adjacent source region.

8. A method for manufacturing a MOS transistor according to claim 6, characterized in that, after the step of etching a first mask serving to delineate the oxidation regions separating each of the individual transistors, while this mask is still in place, and before the oxidation step, it comprises the following steps:
forming a second mask comprising an aperture at least along a lateral stripe overlapping with respect to the source and substrate regions;
implanting a dopant of the conductivity type of the substrate with a high doping level;
annealing;
eliminating the second mask;
oxidizing for insulating the portions wherein the MOS transistors are formed.
